# EUROPÄISCHE PATENTSCHRIFT

(11) **EP 2 891 194 B1**
(45) Veröffentlichungstag und Bekanntmachung des Hinweises auf die Patenterteilung: **20.07.2016**
(21) Anmeldenummer: 13748064.6
(22) Anmeldetag: 13.08.2013
(51) Int. Cl.: H01L 41/27, H01L 41/45

(54) **VERFAHREN ZUR HERSTELLUNG EINES DIELEKTRISCHEN ELASTOMERSTAPELAKTORS**
PROCESS FOR PRODUCING A DIELECTRIC ELASTOMER STACK ACTUATOR
PROCÉDÉ DE FABRICATION D'UN ACTIONNEUR À EMPILEMENT D'ÉLASTOMÈRES DIÉLECTRIQUES

(30) Priorität: 28.08.2012 CH 14962012
(43) Veröffentlichungstag der Anmeldung: 08.07.2015
(73) Patentinhaber: EMPA Eidgenössische Materialprüfungs- und Forschungsanstalt, 8600 Dübendorf (CH)
(72) Erfinder: KOVACS, Gabor, CH-8165 Oberweningen (CH)
(74) Vertreter: Schneider Feldmann AG Patent- und Markenanwälte
(86) Internationale Anmeldenummer: PCT/EP2013/066917
(87) Internationale Veröffentlichungsnummer: WO 2014/032963

(56) Entgegenhaltungen:
- EP-A2- 2 136 419
- CH-A1- 705 539
- ARAROMI O A ET AL: "Spray deposited multilayered dielectric elastomer actuators", SENSORS AND ACTUATORS A, Bd. 167, Nr. 2, Juni 2011 (2011-06), Seiten 459-467, XP055056535, ISSN: 0924-4247, DOI: 10.1016/j.sna.2011.03.004
- LOTZ P ET AL: "Fabrication and application of miniaturized dielectric elastomer stack actuators", IEEE / ASME TRANSACTIONS ON MECHATRONICS, Bd. 16, Nr. 1, Februar 2011 (2011-02), Seiten 58-66, XP011341609, ISSN: 1083-4435, DOI: 10.1109/TMECH.2010.2090164
- JUNGMANN M ET AL: "Taktiles Display mit elektrostatischen Polymer-Aktoren", 47. INTERNATIONALES WISSENSCHAFTLICHES KOLLOQUIUM, TECHNISCHE UNIVERSITÄT ILMENAU, 23.-26. SEPTEMBER 2002, 2002, Seiten 1-9, XP002327545,

## Beschreibung

### Technisches Gebiet

Die vorliegende Erfindung beschreibt ein Verfahren zur Herstellung eines mehrschichtigen dielektrischen Elastomerstapelaktors, umfassend eine Mehrzahl von Dielektrikumlagen bestehend aus mindestens einem verfestigtem Elastomer, welche eingebettet zwischen einer Mehrzahl von Elektrodenlagen angeordnet ist.

### Stand der Technik

Auf elektroaktiven Polymeren oder Elastomeren basierende Aktoren finden zunehmend Interesse in verschiedenen Bereichen der Technik, insbesondere im Automobilbau, der Robotik, der Optik und in der Medizintechnik. Erste kommerzielle Produkte sind in der Optik als Linsen zum Beispiel für Kameras in Handys zu finden. Aber auch die Entwicklung künstlicher Muskeln wird vorangetrieben.

Derartige dielektrische Elastomeraktoren (DEA) setzen elektrische Spannung in mechanische Arbeit um, so dass auch taktile Anwendungen, wie ein taktiler Handschuh oder eine taktile Anzeige für die Braille- Schrift (s. "Miniaturised Electrostatic Tactile Display with High Structural Compliance, M. Jungmann, H:F: Schlaak, in Proceedings of the Conference "Eurohaptics 2002") möglich sind.

Bekannte DEA bestehen aus mindestens einer Dielektrikumlage, bestehend aus einem inkompressiblen Elastomer in Form eines Films oder einer Folie, welches an jeweils einer Oberseite und einer Unterseite beidseitig mit Elektroden beschichtet ist. Beim Anlegen einer elektrischen Spannung an den Elektroden wird ein elektrostatisches Feld zwischen den Elektroden erzeugt, wodurch sich das Elastomermaterial aufgrund der Maxwell Spannung verformt. Bei der Verformung dehnt sich das Material senkrecht zur Feldrichtung aus und wird parallel zur Feldrichtung zusammen gepresst; eine Reduktion der angelegten Spannung bewirkt eine Rückkehr der Dielektrikumlage in seine ursprüngliche Konfiguration. Der dielektrische Elastomeraktor kann nun über den Verformungsweg des Elastomers Arbeit leisten.

Der Struktur einer Kapazität entsprechend wirkt im dielektrischen Elastomeraktor das Elastomer als Dielektrikum, wobei eine möglichst hohe Dielektrizitätskonstante und möglichst hohe elektrische Durchschlagsfestigkeit angestrebt wird. Häufig werden Silikone oder Acryle verwendet, z.Bsp. das acrylische Elastomer VHB4910 von 3M, das grösste Dehnungen (bis 300%) zulässt.

Zum Betrieb einschichtiger dielektrischer Elastomeraktoren werden Betriebsspannungen im Kilovoltbereich von 2kV bis etwa 20 kV benötigt. Derart hohe Betriebsspannungen liegen nahe an der Durchschlagfeldstärke des Elastomers und sind für viele Anwendungen störend. Ein Ausweg wurde in der Entwicklung einer Mehrschichttechnologie und der Schaffung von mehrschichtigen dielektrischen Elastomeraktoren gefunden. Der Nachteil der mit verringerter Deformation dünneren Schichten verbundenen ist, wird durch Stapelung vieler Dielektrikumlagen ausgeglichen. Eine Mehrzahl von dünnen Dielektrikumlagen wird abwechselnd beidseitig mit Elektrodenlagen versehen und zu komplexen dielektrischen Elastomerstapelaktoren gestapelt. Die Anzahl der verwendeten Dielektrikumlagen kann an den gewünschten Verwendungszweck angepasst werden.

Um DEAs in Mehrschichttechnologie zu erreichen, welche mit niedrigeren Betriebsspannungen betreibbar sind, wird eine Herstellung der einzelnen Dielektrikumlagen mit Dicken unterhalb von 100 µm, bevorzugt von wenigen µm angestrebt. Das Herstellungsverfahren muss automatisiert und damit kostengünstig ausgestaltet sein, welches eine reproduzierbare Herstellung der Dielektrikumlagen mit geringen Schwankungen der Dicken gewährleistet, womit mit verringerten Betriebsspannungen betätigbare dielektrische Elastomerstapelaktoren erreichbar sind. Angestrebt werden dielektrische Elastomerstapelaktoren mit bis zu hundert oder mehr Dielektrikumlagen, welche möglichst kostengünstig herstellbar sind.

Aus dem Stand der Technik gemäss XP011341609 oder XP002327545 ist ein Spin-Coating-Verfahren (Rotationsbeschichtungsverfahren) bei Umgebungsbedingungen bekannt, welches geeignet ist, dielektrische Elastomerstapelaktoren mit gewünschten Dicken der Dielektrikumlagen auf einem Schleuderteller schichtweise übereinander zu stapeln. Flüssiges Elastomer wird durch einen statischen Mischer auf ein Substrat auf dem Schleuderteller in einem ersten Dosierungsschritt aufgebracht, wobei der Schleuderteller eine geringe Drehzahl aufweist. Anschliessend wird in einem zweiten Abschleuderschritt mit erhöhter Drehzahl die Zentrifugalbeschleunigung zur Verteilung des Elastomers auf dem Substrat ausgenutzt. Es ist eine Dielektrikumlage mit kontrollierbarer Dicke ausbildbar. Je nach Viskosität des flüssigen Elastomers und der Geschwindigkeit des Schleudertellers wird die Dicke der resultierenden Dielektrikumlage definiert. Um reproduzierbare Dicken der resultierenden Dielektrikumlage zu erreichen muss die Viskosität konstant und die Drehzahl genau, am bestens computergesteuert, regelbar sein. Diese Elastomerbeschichtung läuft automatisiert ab.

Ein ähnliches Verfahren mit Airbrush-Beschichtung auf den Umfang eines rotierenden Rads ist aus XP055056535 bekannt.

Der Vorgang der Rotationsbeschichtung ist technisch gut beherrschbar und führt innerhalb von Minuten zu einer Dielektrikumlage mit der gewünschten Dicke. Der experimentelle Aufbau für den Schleudervorgang ist kompliziert, vor allem was die Steuerungseinheit des Schleudervorganges angeht, damit die geforderten Drehzahlen erreichbar sind.

Die erreichbare Homogenität und Oberflächenqualität wird durch die Ausbildung von sogenanntem Schattenwurf, Blasenbildung, unvollständige Bedeckung der Substratoberfläche und Mitten- und/oder Randüberhöhungen gestört. Es ist keinesfalls trivial eine Vielzahl von Dielektrikumlagen bestehend aus einem Elastomer mit ausreichender Homogenität und geforderter Oberflächengüte in einem Verfahren mit möglichst wenig Ausschuss zu erreichen.

Nach jedem Elastomerbeschichtungsschritt muss ein räumlich getrennter Vernetzungsschritt unter Zuführung thermischer Energie, beispielsweise durch elektromagnetische Strahlung in Form von Infrarot oder UV-Strahlung angeschlossen werden. Nach der Erzeugung der Dielektrikumlage muss dem Substrat thermische Energie zugeführt werden, was durch Positionierung des Schleudertellers unter eine IR-Strahlungsquelle erfolgen kann. Dazu muss entsprechend der Beschichtungsvorgang unterbrochen werden und eine meist einige Minuten dauernde Vernetzungsunterbrechung durchlaufen werden.

Erst nach dem Vernetzungsschritt kann die Elektrodenlage auf dem Elastomer abgeschieden werden. Durch den Vernetzungsschritt ist eine ausreichende Stabilisierung der Dielektrikumlage gewährleistet, welche auch eine dauerhafte Fixierung der Elektrodenlage erlaubt.

An diesen bekannten Verfahren ist nachteilig, dass jeweils ein, den Beschichtungsvorgang unterbrechender, Vernetzungsschritt stattfinden muss, bevor die Elektrodenlage abscheidbar ist. Aufgrund des Schleudervorganges muss das Substrat speziell stabilisiert werden. Da die Elastomerbeschichtung auf Grund variierender Viskosität des Elastomers temperatur- und zeitkritisch ist, ist das bekannte Verfahren auf grund unterschiedlich wechselnder Positionierung und Bewegung des Substrates nachteilig.

Auch aus XP002668832 Punning et. al "Multilayer Dielectric Elastomer Actuators with Ion Implanted Electrodes" geht die schichtweise Herstellung eines dielektrischen Elastomerstapelaktors hervor, wobei ein Silikon (PDMS, Polydimethylsiloxan) als Elastomer verwendet wird und eine optimierte Ausbildung der Elektrodenlagen erreicht wird. Dielektrikumlagen aus PDMS werden einzeln gegossen und anschliessend thermisch behandelt. Eine teilweise Vernetzung (partial curing) der Elastomerschichten mit einem Vernetzungsgrad < 100 % muss nach jedem Gussvorgang stattfinden. Eine teilweise Vernetzung ist eine effektive und günstige Methode um Laminatstrukturen herzustellen. Diese Vernetzung findet bei niedrigen Temperaturen statt. Durch die teilweise Vernetzung bleibt das Elastomer an der Oberfläche teilweise unvernetzt und kann entsprechend in einem späteren Schritt mit anderen teilweise vernetzten Schichten zusätzlich vernetzt werden.

Durch die thermische Behandlung ist die Dielektrikumlage teilvernetzt, was notwendig ist, um eine Elektrodenlage mittels Ionenimplantation aufzubringen. Eine Ionenimplantation führt zu unlösbar verbundenen homogen ausgeführten Elektrodenlagen, welche fest an die Dielektrikumlage gebunden sind. Durch die Teilvernetzung kann die Dielektrikumlage in einem späteren Schritt mit einer weiteren Dielektrikumlage unter Ausbildung chemischer Bindungen verbunden werden. Dieses Herstellungsverfahren ist äusserst zeit- und temperaturkritisch. Nur wenn die Verfahrensparameter exakt eingehalten werden, binden sich benachbarte Dielektrikumlagen, womit erst stabile gewünschte DEAs erreichbar sind. Die teilweise Vernetzung, die Ionenimplantation und der nächste Giessvorgang der folgenden Dielektrikumlage müssen zeitlich genau abgestimmt sein, damit sich ein quasi monolithischer dielektrischer Elastomerstapelaktor erzeugen lässt.

Der schichtweise Aufbau bedingt aufwändige Herstellungsschritte und muss immer wieder unterbrochen werden, damit der jeweils folgende Produktionsschritt durchführbar ist. Die Herstellungsparameter müssen genau stimmen, damit die Fixierung der Elektrodenlagen und die Vernetzung der einzelnen Elastomerlagen miteinander wie gewünscht stattfinden kann. Dieses Verfahren ist zur Herstellung von EAP-Stapeln mit einigen wenigen Elastomerlagen verwendbar, aber für die Herstellung von aufwändigen Stapeln nachteilig. Um eine Elektrodenlage auf der Dielektrikumlage zu platzieren, muss vor Ionenimplantation mindestens eine Teilvernetzung durchgeführt werden, damit die Partikel auf der Oberfläche der Dielektrikumlage kontrolliert und in ausreichender Schichtdicke abscheidbar sind.

### Darstellung der Erfindung

Die vorliegende Erfindung hat sich zur Aufgabe gestellt ein vereinfachtes Herstellungsverfahren zur Erzeugung von dielektrischen Elastomerstapelaktoren oder -sensoren in Mehrschichttechnologie zu schaffen.

Die Vereinfachung wird dadurch erreicht, dass Dielektrikumlagen aus mindestens einem Elastomer mit einer Rastervorrichtung auf ein örtlich fixiertes ruhendes Substrat aufgebracht werden und die Aufbringung der nächsten Elektrodenlage direkt anschliessend ohne Vorvernetzungsschritt des Elastomers direkt auf die Dielektrikumlage stattfindet. Erstaunlicherweise ist kein Vorvernetzungsschritt vor Aufbringen der Elektrodenlage notwendig. Das Aufbringen des Elastomers und der folgenden Elektrodenlage auf die jeweils nächste Substratoberfläche erfolgt ohne Kontakt eines Elastomerbeschichtungskopfes bzw. einer Elektrodenbeschichtungsvorrichtung kraftlos bzw. berührungslos.

Mit dem beschriebenen Verfahren ist die Herstellung von quasi monolithischen dielektrischen Elastomerstapelaktoren möglich, wobei die Mehrzahl von Dielektrikumlagen miteinander vernetzt einen gekapselten DEA bilden.

Die aus dem Stand der Technik bekannten Herstellungsverfahren führen zwingend einen zumindest teilweise ausgeführten Vernetzungsschritt der Dielektrikumlage vor Ausbildung der Elektrodenlage durch. Damit führt der Stand der Technik von dem erfindungsgemässen Verfahren weg. Die Verfahrensschritte Erstellung einer Dielektrikumlage, einer Elektrodenlage und anschliessende Vernetzung sind aufeinander abgestimmt und so gewählt, dass eine derartig gewählte Reihenfolge der Herstellungsschritte zum Ziel führt. Die Umkehrung der Schrittreihenfolge führt überraschenderweise zu Elastomeraktoren mit gewünschten Eigenschaften.

Dadurch, dass das Elastomer der Dielektrikumlagen vor Auftragen der Elektrodenlage nicht vorvernetzt wird, erfolgt eine verteilung der Elektrodenlagenpartikel auf der unvernetzten Dielektrikumlage, sodass bei der anschliessenden Vernetzung eine verbesserte Verankerung erreicht wird.

### Kurze Beschreibung der Zeichnungen

Ein bevorzugter Aufbau zur Herstellung, der schrittweise Ablauf des Herstellungsverfahrens und ein resultierender mehrschichtiger dielektrischer Elastomerstapelaktor werden nachstehend im Zusammenhang mit den anliegenden Zeichnungen beschrieben.
- Figur 1a: zeigt einen Aufbau zum Aufbringen von Dielektrikumlagen aus Elastomeren mit einer Rastervorrichtung in einer perspektivischen Ansicht, während
- Figur 1b: eine Schnittansicht eines erzeugten quasi monolithischen dielektrischen Elastomerstapelaktors mit n=11 Dielektrikumlagen zeigt.
- Figur 2a: zeigt in einer schematischen Schnittansicht das Aufbringen einer ersten Dielektrikumlage auf die ruhende Substrathalterung gemäss Schritt i), während
- Figur 2b: das direkt anschliessende Erzeugen einer ersten Elektrodenlage auf die unvernetzte Dielektrikumlage gemäss Schritt ii) und
- Figur 2c: die abschliessende mindestens teilweise Vernetzung der Dielektrikumlage gemäss Schritt iii) zeigt, wobei die Elektrodenlage fest mit der Dielektrikumlage verbunden wird und die Dielektrikumlage mechanisch stabilisiert wird.

### Beschreibung

Im Folgenden wird ein Herstellungsverfahren von dielektrischen Elastomerstapelaktoren (DEA) 4 vorgestellt, welches im Vergleich zu aus dem Stand der Technik bekannten Verfahren vereinfacht ist. Anstelle von dielektrischen Elastomerstapelaktoren 4 sind auch dielektrischen Elastomerstapelsensoren herstellbar, welche bekanntermassen passive Bauelemente zur Detektion von Signalen sind.

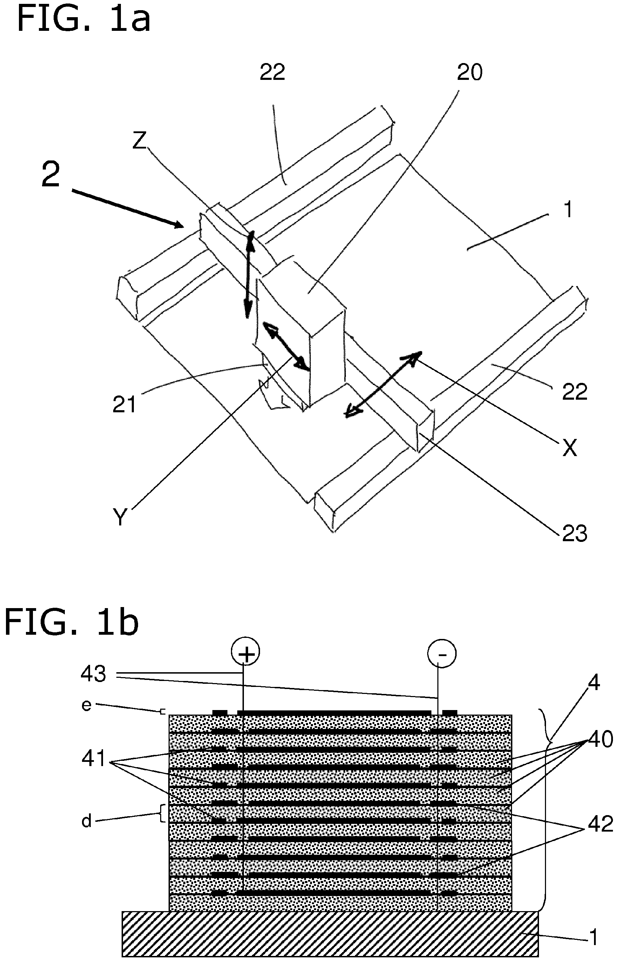

In Figur 1a ist eine Vorrichtung umfassend eine Substrathalterung 1 und eine Rastervorrichtung 2 schematisch perspektivisch dargestellt. Die Rastervorrichtung 2 umfasst hier zwei Längsschienen 22 und einen darin in der x-Richtung bewegbaren Querträger 23 auf. Auf den Längsschienen 22 ist der Querträger 23 längs verfahrbar angeordnet.

Am Querträger 23 ist ein Elastomerbeschichtungskopf 20 als Ausbringeinheit befestigt, welcher in einer y-Richtung und einer z-Richtung bewegbar gelagert ist. Die x-, y- und z-Richtungen sind orthogonal zueinander ausgerichtet.
Ein Vorrats- bzw. Mischbehälter für auszubringendes flüssiges Elastomer ist im oder am Elastomerbeschichtungskopf 20 vorgesehen, aus welchem mindestens ein flüssiges Elastomer aus dem Elastomerbeschichtungskopf 20 abgebbar ist.

Durch eine Beschichtungsdüse 21 wird auf dem Substrat ein Film aus flüssigem Elastomer abgelegt, wobei durch geeignetes Verfahren des Elastomerbeschichtungskopfes 20 zusammen mit der Ansteuerung der Beschichtungsdüse 21 eine beliebige Kontur der abgelegten Elastomerschicht erzeugt werden kann. Als Substrat wird zu Beginn der Herstellung die Oberfläche der Substrathalterung 1 und nach Herstellung einer n-ten Dielektrikumlage 40 bzw. ersten oder zweiten Elektrodenlage 41, 42 die Oberfläche des jeweils vorgängig aufgebrachten Materials bezeichnet.

Mit einer nicht dargestellten Steuereinrichtung und Antriebseinrichtung ist der Elastomerbeschichtungskopf 20 in kontrollierten Höhen über die örtlich fixierte Substrathalterung 1 reproduzierbar gesteuert führbar. Am Elastomerbeschichtungskopf 20 ist die Beschichtungsdüse 21 befestigt, mittels welcher eine kontrollierte Menge eines flüssigen Elastomers auf die Substrathalterung 1 bzw. auf die jeweils der Beschichtungsdüse 21 direkt zugewandten nächstliegende Substratoberfläche abgelegt werden kann.

Durch die Steuereinrichtung ist die gesteuerte Bewegung der Rastervorrichtung 2, des Elastomerbeschichtungskopfes 20 und damit der Beschichtungsdüse 21 in einer kontrollierbaren fixierten Höhe h zur jeweils obersten Lage des Substrates erreichbar. Damit ist das Ablegen von Dielektrikumlagen 40 mit reproduzierbaren Lagendicken d möglich.

Wie in Figur 1b erkennbar weist ein fertiger DEA 4 eine sandwichStruktur aus erster Elektrodenlage 41, Dielektrikumlage 40 und zweiter Elektrodenlage 42 auf. Ein fertiger Elastomerstapelaktor 4 kann beidseitig Abschlussflächen in Form von Dielektrikumlagen 40 oder Abschlussflächen in Form jeweils einer Elektrodenlage 41, 42 aufweisen.

Beispielhaft ist hier eine erste Elektrodenlage 41 auf der von der Substrathalterung 1 beabstandet angeordneten Abschlussfläche erzeugt worden, welche mit einem positiven Pol einer Spannungsquelle verbindbar ist. Jeweils auf der der ersten Elektrodenlage 41 gegenüberliegenden Fläche einer Dielektriukumlage 40 ist eine zweite Elektrodenlage 42 angeordnet, welche jeweils mit einem negativen Pol einer Spannungsquelle verbindbar ist. Durch Vervielfachung dieser abwechselnden Anordnung von erster Elektrodenlage 41, Dielektrikumlage 40 und zweiter Elektrodenlage 42 können die gewünschten dielektrischen Elastomerstapelaktoren 4 erstellt werden. Durch das Anlegen einer äusseren elektrischen Spannung an die Elektrodenlagen 41, 42 mittels Anschlussleitungen 43 ist der DEA 4 auslenkbar.

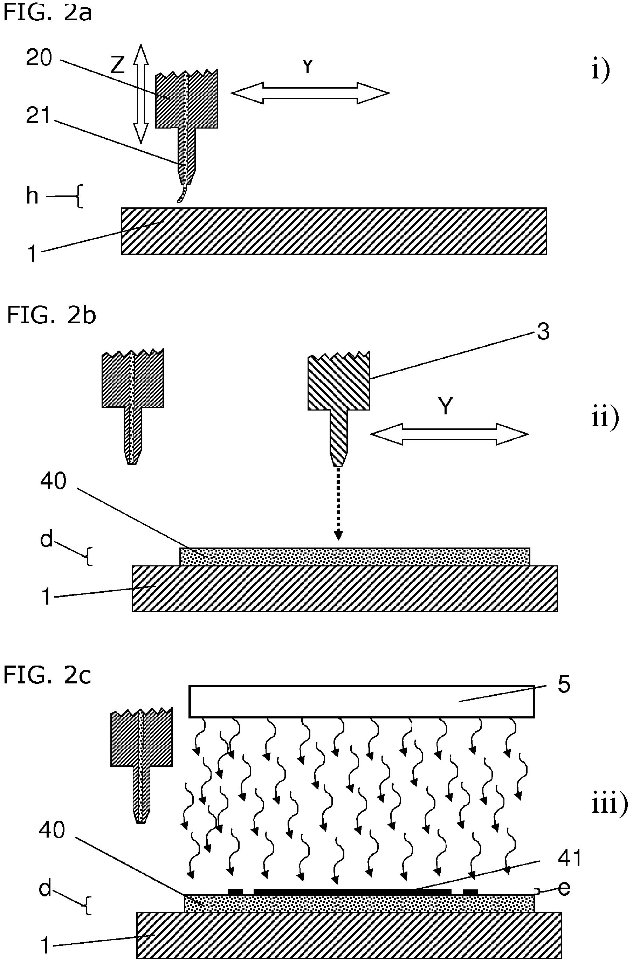

Durch einen schichtweisen Aufbau des dielektrischen Elastomerstapelaktors 4, wobei die Dielektrikumlagen 40 jeweils mindestens teilweise vernetzt werden, wird ein gekapselter quasi monolithischer Elastomerstapelaktor 4 ausgebildet, welcher mechanisch derart stabil ist, dass beispielsweise künstliche Muskeln damit herstellbar sind. Die einzelnen Schritte des Herstellungsprozesses und vor allem deren Reihenfolge werden im Folgenden anhand der Figuren 2 beschrieben.

In einem ersten Schritt i) wird eine kontrollierte Menge flüssigen Elastomers mittels Beschichtungsdüse 21 auf die Substrathalterung 1 aufgebracht. Diese Beschichtung findet auf einer ortsfest gehaltenen ruhenden Substrathalterung 1 statt.

Durch Bewegung der Rastervorrichtung 2 wird der Elastomerbeschichtungskopf 20 und damit die Beschichtungsdüse 21 in einer festen Höhe h über die jeweils der Beschichtungsdüse 21 zugewandten nächsten Oberfläche des Substrates geführt. In Figur 2a wird das flüssige Elastomer direkt auf die Oberfläche der Substrathalterung 1 aufgebracht. Dabei wird flüssiges Elastomer mit einer resultierenden Lagendicke d von wenigen Mikrometern abgelegt.

Durch geeignete Wahl der Höhe h der Beschichtungsdüse 21 vom Substrat, der Austrittsgeschwindigkeit des zu vergiessenden Elastomers und der Vorschubgeschwindigkeit des Elastomerbeschichtungskopfes 20 in Y-Richtung oder X-Richtung, lassen sich Dielektrikumlagen 40 mit Lagendicken d von 30 µm oder weniger, bevorzugt mit Lagendicken d zwischen 10 µm und 20 µm herstellen. Wie oben erwährt, sind sehr dünne Dielektrikumlagen 40 anzustreben, da dadurch die vom Elastomerstapelaktor 4 erzeugte Kraft vergrössert werden kann. Generell ist es für die Bildung einer einwandfreien Dielektrikumlage 40 vorteilhaft, dass die Höhe h der Beschichtungsdüse 21 zur zu beschichtenden Oberfläche im Bereich vom 1,5 fachen der Lagendicke d gehalten wird.

Direkt an den Beschichtungsschritt i) anschliessend wird die Oberfläche des unvernetzten Elastomers der zuletzt gegossenen Dielektrikumlage 40 mit elektrisch leitfähigen Partikeln in einem zweiten Schritt ii) beschichtet.

Nachdem die Rastervorrichtung 2 den Elastomerbeschichtungskopf 20 in eine von der zuletzt gegossenen Substratoberfläche entfernte Parkposition bewegt hat, wird eine Elektrodenbeschichtungsvorrichtung 3 über der Substratoberfläche platziert. Um die Bedeckung der Oberfläche mit elektrisch leitfähigen Materialpartikeln zu erreichen, weist die Elektrodenbeschichtungsvorrichtung 3 eine Düse auf, welche plotterartig in x-Richtung und y-Richtung bei einem festen Abstand in z-Richtung über die Dielektrikumlage 40 geführt wird. Die Materialpartikel werden vorgängig in einem Lösungsmittel gelöst, beispielsweise kann dazu Isopropanol als Dispersionsmittel gewählt werden. Es wird eine Trägersuspension gebildet, mittels welcher die Materialpartikel in flüssiger Form auf die Substratoberfläche aufgebracht werden. Die Abgabe der Trägersuspension mit Elektrodenmaterial erfolgt ohne Kontakt der Elektrodenbeschichtungsvorrichtung mit der Substratoberfläche berührungslos bzw. kraftlos auf die Substratoberfläche.

Beim reproduzierbaren Aufbringen von elektrisch leitfähigen Materialpartikeln auf die Oberfläche des flüssigen Elastomers bildet sich eine Elektrodenlage 41, 42 unter Ausnutzung der Oberflächenspannung des unvernetzten Elastomers aus. Die elektrisch leitfähigen Materialpartikel lagern sich auf der Oberfläche ab und bei geeigneter Menge der Materialpartikel bildet sich eine geschlossene ausreichend leitfähige Elektrodenlage 41, 42 mit bestimmter Elektrodenlagendicke e. Die Materialpartikel liegen stabil auf der unvernetzten Oberfläche des Elastomers und diffundieren aufgrund der Oberflächenspannung nur äusserst wenig in die Dielektrikumlage 40 hinein.

Als elektrisch leitfähige Materialpartikel kommen Kohlenstoffpartikel in unterschiedlichen Strukturformen in Frage, aber auch Metallpartikel. Verwendbare Materialpartikel weisen eine Grösse von weniger als einem Mikrometer auf. Als Elektrodenmaterial kann Graphitpulver, graphithaltige Paste oder leitfähiger Russ auf die jeweils vorab erzeugte Dielektrikumlage 40 bei Reinraumbedingungen aufgebracht werden. Es können neben Kohlenstoff-Nanoröhren Silber nano-wire und andere Materialpartikel mit Abmessungen kleiner als ein Mikrometer verwendet werden. Vorteilhaft ist die Verwendung von Materialpartikeln in Form von Nanopartikeln und damit Grössen von kleiner gleich 100 Nanometern.

Der Flüssigkeitsstrahl der Trägersuspension mit darin gelösten Materialpartikeln wird mittels Piezoantrieb gesteuert, wobei zwischen tropfenweisem und strahlweisem Auslass gewählt werden kann. Durch die Steuerbarkeit unterschiedlich hoher Durchflüsse der Trägersuspension kann der Materialauftrag auf die gewünschte Rastergeschwindigkeit eingestellt werden.

Erst nach Erzeugung der ersten bzw. zweiten Elektrodenlage 41, 42, mit einer Elektrodenlagendicke e, wird in einem dritten Schritt iii) eine mindestens teilweise Vernetzung des Elastomers der Dielektrikumlage 40 angeschlossen.

Ebenfalls unter Reinraumbedingungen mit im einfachsten Fall ruhenden örtlich fixierten Substrathalter 1, wird ein Vernetzungsschritt angeschlossen. Mittels einer Vernetzungsvorrichtung 5 wird unter Zuführung von thermischer Energie und/oder Strahlungsenergie, beispielsweise in Form von Infrarotstrahlung oder UV-Strahlung, die Dielektrikumlage 40 mindestens teilweise vernetzt. Als Vernetzungsvorrichtung 5 kommt neben einem Ofen, eine entsprechende Strahlungsquelle in Frage. Die auf der Oberfläche der vorgängig gegossenen Dielektrikumlage 40 schwimmend aufliegende Elektrodenlage 41, 42 wird dadurch ebenfalls durch die thermische Behandlung und/oder Bestrahlung auf der Dielektrikumlage 40 unlösbar fixiert.

Versuche haben gezeigt, dass die mindestens teilweise Vernetzung der Dielektrikumlage 40 gemäss Schritt iii) bis zu einem Vernetzungsgrad von mindestens 10 % bis maximal 50% erfolgen sollte.

Je nach gewünschter Anzahl n der Dielektrikumlagen 40 werden die Schritte i) bis iii) entsprechend oft wiederholt. Hier beispielhaft dargestellt ist ein dielektrischer Elastomerstapelaktor 4, dessen erste Dielektrikumlage 40 direkt auf der Substrathalterung 1 angeordnet ist, sodass diese nur einseitig mit einer Elektrodenlage 41 verbunden ist. Es ist aber auch möglich jede Dielektrikumlage 40 jeweils beidseitig mit Elektrodenlagen 41, 42 zu umgeben. Nachdem der DEA schichtweise aufgebaut wurde, können die Anschlussleitungen 43 senkrecht, beispielweise in Form von Drähten, durch den Stapel geführt werden, wodurch jeweils übernächste benachbarte Elektrodenlagen 41, 42 miteinander leitend verbindbar sind.

Alle Verfahrensschritte i) bis iii) laufen unter Reinraum- oder Reinstraumbedingungen und bei ortsfest gehaltener Substrathalterung 1 bzw. örtlich fixiertem ruhenden Substrat ab. Versuche haben gezeigt, dass die Reinraumbedingungen mindestens der Klasse 100 (US FED STD 209E) bzw. der Klasse ISO5 (ISO 14644-1) entsprechen sollten, um hochreine Lagen zu erzeugen. Die Raumtemperatur und der vorherrschende Luftdruck liegen üblicherweise im Bereich von 25°C und bei Atmosphärendruck. Entscheidend ist aber vor allem die Reinheit der Luft.

### Beispiel:

Gute Ergebnisse homogener Dielektrikumlagen 40 mit geeigneter Lagendicke d wurden unter Verwendung einer Schlitzdüse 21 als Beschichtungsdüse 21 erreicht. Zur Erreichung von Lagendicken d der Dielektrikumlagen 40 von 40µm wurden die folgenden Parameter verwendet:
- Schlitzlänge der verwendeten Schlitzdüse 21: 40 mm
- Schlitzbreite der verwendeten Schlitzdüse 21: 50µm
- Viskosität des Elastomers ( SEMICOSIL 945UV A/B von der Wacker Chemie AG): 1000 mPa.s
- Vorschubgeschwindigkeit des Elastomerbeschichtungskopfes 20 bzw. der Schlitzdüse 21 relativ zur Unterlage: 2 mm/s
- Höhe h der Schlitzdüse 21 von der jeweils der Schlitzdüse 21 direkt zugewandten Substratoberfläche: 60µm
- Durchfluss des Elastomers durch die Schlitzdüse 21: 3,2 µl/s

### Optionen:

Die Elektrodenbeschichtungsvorrichtung 3 kann optional auch an den Elastomerbeschichtungskopf 20 angebracht oder in diesen integriert sein, damit der Schritt ii) der Elektrodenbeschichtung zeitnah an den ersten Schritt i) anschliessbar ist und die gleiche Rastervorrichtung 2 nutzbar ist.

Hier dargestellt sind erste und zweite Elektrodenlagen 41, 42, welche identische Elektrodenlagendicken e aufweisen. Es ist aber ebenfalls möglich die Elektrodenlagendicken e geringfügig unterschiedlich auszuführen. In der Regel sind die Elektrodenlagendicken e kleiner als die Lagendicken d der Dielektrikumlagen 40.

Da das Elektrodenmaterial auf unvernetzte und damit mechanisch instabile Dielektrikumlagen 40 aufgesprüht oder gestäubt wird, können einige Partikel geringfügig in die Oberfläche der Dielektrikumlage 40 hineindiffundieren. Durch die Durchführung des Vernetzungsschrittes nach der Beschichtung des Elastomers mit elektrisch leitfähigen Partikeln, resultiert eine äusserst feste Verbindung zwischen Elektrodenlage 41, 42 und Dielektrikumlage 40.

Als Elastomermaterial können Silikone, 1- oder 2-Komponenten-Silikonkautschuke oder Acryle verwendet werden, welche entsprechend durch Bestrahlung und/oder thermische Energie vernetzen. Die Viskosität des verwendeten Elastomermaterials sollte bei kleiner gleich 1500 mPas liegen, damit ein ausreichend zügiges Aufbringen des Elastomermaterials durchführbar ist.

Ein Verdünnen der verwendeten Elastomere ist aufgrund der variierenden Lagendicke d und der gesteigerten Diffusion der Elektrodenlagenpartikel erschwert einzustellen, aber möglich.

Um die mechanische Stabilität des mehrschichtigen dielektrischen Elastomerstapelaktors 4 zu erhöhen, kann ein zusätzlicher Vernetzungsschritt zur Verkapselung der n Dielektrikumlagen 40 und der Elektrodenlagen 41, 42 im Randbereich des Elastomerstapelaktors 4, nach n-maliger Durchführung der Schritte i) bis iii) durch weitere Zuführung von Wärme angeschlossen werden.

### Bezugszeichenliste

- 1: Substrathalterung
- 2: Rastervorrichtung

- 20: Elastomerbeschichtungskopf
- 21: Beschichtungsdüse h Höhe der Beschichtungsdüse zur zu beschichtenden Oberfläche
- 22: Längsschiene
- 23: Querträger

- 3: Elektrodenbeschichtungsvorrichtung
- 4: dielektrische Elastomerstapelaktoren / EAP-Stapel

- 40: Dielektrikumlage (1 bis n) d Lagendicke
- 41: erste Elektrodenlage/positiv
- 42: zweite Elektrodenlage/negativ e Elektrodenlagendicke
- 43: Anschlussleitungen (Spannungsversorgung bzw. Sensorleitungen)

- 5: Vernetzungsvorrichtung /Ofen oder thermischer Strahler (IR- oder UV)

## Patentansprüche

1. Verfahren zur Herstellung eines mehrschichtigen dielektrischen Elastomerstapelaktors (4), umfassend
eine Mehrzahl von Dielektrikumlagen (40) bestehend aus mindestens einem verfestigtem Elastomer, welche eingebettet zwischen einer Mehrzahl von Elektrodenlagen (41, 42) angeordnet ist,
**gekennzeichnet durch** die Schritte:
i) Aufbringen eines flüssigen unvernetzten Elastomers zur Bildung der Dielektrikumlage (40) mit reproduzierbarer Lagendicke (d) kleiner als 50µm mittels einer Rastervorrichtung (2) auf ein Substrat, daran direkt anschliessendes
ii) Aufbringen von elektrisch leitfähigen Materialpartikeln auf die Oberfläche der Dielektrikumlage (40) aus flüssigem Elastomer, zur Bildung einer Elektrodenlage (41, 42) unter Ausnutzung der Oberflächenspannung des Elastomers und eine abschliessende
iii) mindestens teilweise Vernetzung der Dielektrikumlage (40) mit auf der Oberfläche schwimmend aufliegender Elektrodenlage (41, 42) **durch** thermische Behandlung und/oder Bestrahlung,
und
Wiederholung der Schritte i) bis iii),
wobei alle Schritte
unter Reinraumbedingungen und
bei ortsfest gehaltener ruhender Substrathalterung (1) und Substrat ablaufen.

2. Verfahren nach Anspruch 1, **wobei** das Aufbringen der Elektrodenlage (41, 42) durch ein tropfenweises oder strahlweises Aufbringen eines Flüssigkeitsstrahles einer Trägersuspension mit darin dispergierten elektrisch leitfähigen Materialpartikeln auf die unvernetzte Dielektrikumlage (40) bei ruhendem Substrat erfolgt.

3. Verfahren nach Anspruch 1, **wobei** das Aufbringen des flüssigen Elastomers durch Ablegen des Elastomers mit definierbarer Menge mittels über die Oberfläche des Substrates rasterbare Beschichtungsdüse (21) in einer definierten Höhe (h) erreicht wird.

4. Verfahren nach Anspruch 1, **wobei** die mindestens teilweise Vernetzung gemäss Schritt iii) bis zu einem Vernetzungsgrad von mindestens 10 % erfolgt.

5. Verfahren nach Anspruch 1, **wobei** die mindestens teilweise Vernetzung gemäss Schritt iii) bis zu einem Vernetzungsgrad bis maximal 50% erfolgt.

6. Verfahren nach Anspruch 1, **wobei**
nach n-maliger Durchführung der Schritte i) bis iii) und Fertigstellung des gewünschten mehrschichtigen dielektrischen Elastomerstapelaktors (4) ein zusätzlicher Vernetzungsschritt zur Verkapselung der n Dielektrikumlagen (40) und der Elektrodenlagen (41, 42) im Randbereich des Elastomerstapelaktors (4) angeschlossen wird.

7. Verfahren nach einem der vorhergehenden Ansprüche, **wobei** die teilweise Vernetzung gemäss Schritt iii) mittels Infrarotstrahlung oder UV-Strahlung erfolgt.

8. Verfahren nach einem der vorhergehenden Ansprüche, **wobei** die elektrisch leitfähigen Partikel Nanopartikel aus Kohlenstoff oder Metall sind.

## Claims

1. A process for producing a multilayer dielectric elastomer stack actuator (4), comprising a plurality of dielectric layers (40) consisting of at least one solidified elastomer that is arranged embedded between a plurality of electrode layers (41, 42), **characterized by** the steps of:
i) applying a liquid, non-crosslinked elastomer onto a substrate in order to form the dielectric layer (40) with a reproducible layer thickness (d) of less than 50 µm by means of a screen device (2), immediately thereafter
ii) applying electrically conductive material particles onto the surface of the dielectric layer (40) of liquid elastomer in order to form an electrode layer (41, 42) by utilizing the surface tension of the elastomer, subsequently
iii) at least partially crosslinking the dielectric layer (40) with an electrode layer (41, 42) lying on the surface in a floating fashion by means of a thermal treatment and/or irradiation, and
repeating steps i) through iii),
wherein all steps
are carried out under clean room conditions and
while the substrate holder (1) and the substrate are stationarily held in position.

2. The process according to claim 1, wherein the application of the electrode layer (41, 42) is realized by applying a liquid jet of a carrier suspension with electrically conductive material particles dispersed therein onto the non-crosslinked dielectric layer (40) drop by drop or jet by jet while the substrate is stationarily held in position.

3. The process according to claim 1, wherein the application of the liquid elastomer is achieved by depositing the elastomer in a defined quantity by means of a coating nozzle (21) that can be screened over the surface of the substrate in a defined height (h).

4. The process according to claim 1, wherein the at least partial crosslinking according to step iii) is carried out until a crosslinking degree of at least 10% is reached.

5. The process according to claim 1, wherein the at least partial crosslinking according to step iii) is carried out until a crosslinking degree of no more than 50% is reached.

6. The process according to claim 1, wherein an additional crosslinking step for encapsulating the n dielectric layers (40) and the electrode layers (41, 42) in the edge region of the elastomer stack actuator (4) is carried out after steps i) though iii) have been carried out n-times and the desired multilayer dielectric elastomer stack actuator (4) has been completed.

7. The process according to one of the preceding claims, wherein the partial crosslinking according to step iii) is carried out by means of infrared radiation or UV radiation.

8. The process according to one of the preceding claims, wherein the electrically conductive particles are nanoparticles of carbon or metal.

## Revendications

1. Procédé de fabrication d'un actionneur d'empilement élastomère diélectrique à plusieurs couches (4), comprenant
une pluralité de couches diélectriques (40) constituées d'au moins un élastomère renforcé, lesquelles sont enrobées entre une pluralité de couches d'électrodes (41, 42),
**caractérisé par** les étapes suivantes :
i) application d'un élastomère non réticulé liquide pour la formation de la couche diélectrique (40) avec une épaisseur de couche reproductible (d) inférieure à 50 µm, à l'aide d'un dispositif de grille (2) sur un substrat, suivie directement par
ii) l'application de particules de matériau électriquement conductrices sur la surface de la couche diélectrique (40) constituée d'un élastomère liquide, pour la formation d'une couche d'électrodes (41, 42), à l'aide de la tension de surface de l'élastomère, suivie finalement par
iii) la réticulation au moins partielle de la couche diélectrique (40) avec la couche d'électrodes (41, 42) reposant de façon flottante sur la surface, par un traitement thermique et/ou par rayonnement, et
la répétition des étapes i) à iii), sachant que toutes les étapes se déroulent dans des conditions de salle blanche tandis que le support de substrat (1) et le substrat sont maintenus fixement au repos.

2. Procédé selon la revendication 1, dans lequel l'application de la couche d'électrodes (41, 42) est effectuée par une application sous forme de gouttes ou de jet d'un jet de liquide d'une suspension de support, avec des particules de matériau électriquement conductrices dispersées dans celui-ci, sur la couche diélectrique (40) non réticulée, tandis que le substrat est au repos.

3. Procédé selon la revendication 1, dans lequel l'application de l'élastomère liquide est réalisée par dépôt de l'élastomère en une quantité définissable, à l'aide de buses de revêtement (21) encliquetables sur la surface du substrat, à une hauteur définie (h).

4. Procédé selon la revendication 1, dans lequel la réticulation au moins partielle selon l'étape iii) jusqu'à un certain degré de réticulation est effectuée jusqu'à 10% maximum.

5. Procédé selon la revendication 1, dans lequel la réticulation au moins partielle selon l'étape iii) jusqu'à un certain degré de réticulation est effectuée jusqu'à 50% maximum.

6. Procédé selon la revendication 1, dans lequel après exécution des étapes i) à iii) n fois et réalisation de l'actionneur d'empilement élastomère diélectrique à plusieurs couches (4) souhaité, une étape de réticulation supplémentaire est ajoutée pour l'encapsulation des n couches diélectriques (40) et des couche d'électrodes (41, 42) dans la région marginale de l'actionneur d'empilement élastomère (4).

7. Procédé selon l'une des revendications précédentes, dans lequel la réticulation partielle selon l'étape iii) est effectuée à l'aide d'un rayonnement infrarouge ou d'un rayonnement UV.

8. Procédé selon l'une des revendications précédentes, dans lequel les particules électriquement conductrices sont des nanoparticules constituées de carbone ou de métal.
